# DEMANDE DE BREVET EUROPEEN

(11) **EP 3 650 576 A1**
(43) Date de publication de la demande: **13.05.2020**
(21) Numéro de dépôt: 19207888.9
(22) Date de dépôt: 08.11.2019
(51) Int. Cl.: C23C 14/08, C23C 14/34, C23C 14/35, H01L 51/42, H01L 51/44

(54) **PROCÉDÉ POUR LA FORMATION D'UNE ÉLECTRODE TRANSPARENTE**

(30) Priorité: 09.11.2018 FR 1871441
(71) Demandeur: Commissariat à l'énergie atomique et aux énergies alternatives, 75015 Paris (FR)
(72) Inventeur: MANCEAU, Matthieu, 38054 Grenoble Cedex 09 (FR); BERSON, Solenn, 38054 Grenoble Cedex 09 (FR); MUNOZ, Maria-Delfina, 38054 Grenoble Cedex 09 (FR)
(74) Mandataire: Nony

(57) **Abrégé**

L'invention concerne à titre principal un procédé utile pour former une électrode supérieure en oxyde conducteur transparent (TCO) au contact d'une couche conductrice de type N d'un empilement pérovskite (PSCs) de type PIN ou d'une couche conductrice de type P d'un empilement pérovskite (PSCs) de type NIP

## Description

La présente invention se rapporte au domaine des dispositifs photovoltaïques, notamment des cellules photovoltaïques de type pérovskite et vise plus particulièrement à proposer des électrodes transparentes, de préférence dites supérieures ou « top électrode » avantageuses pour ces cellules.

Les dispositifs photovoltaïques, et en particulier les cellules photovoltaïques, comprennent un empilement multicouche, comportant une couche photo-active, dite couche « active ». Cette couche active des cellules photovoltaïques est au contact de part et d'autre avec une couche de type N et une couche de type P. Ce type d'ensemble multicouche, constitué de la superposition de la couche active et des deux couches de type P et de type N décrites ci-dessus est classiquement dénommé NIP ou PIN suivant l'ordre d'empilement des différentes couches sur le substrat. Dans les cellules photovoltaïques dites de type pérovskites, la couche active est constituée d'un matériau de type pérovskite hybride organique-inorganique.

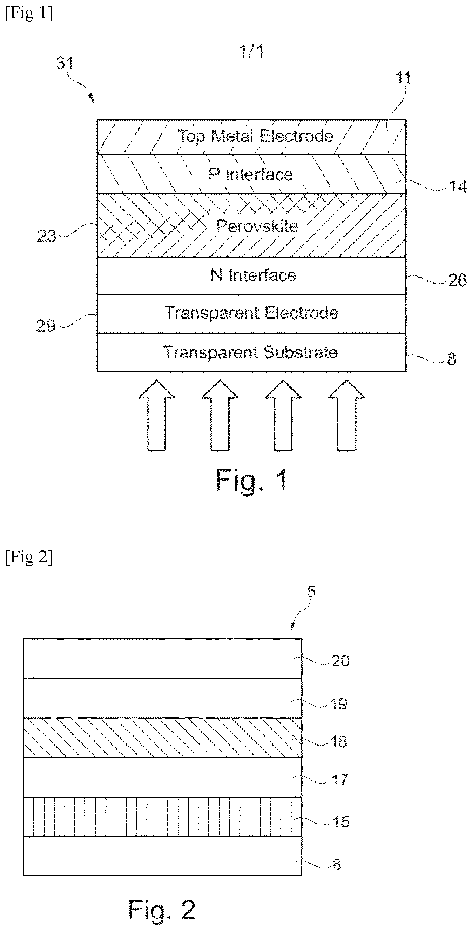

Comme illustré de manière schématique en figure 1, une cellule photovoltaïque de type pérovskite de type NIP, comporte généralement, dans un plan vertical de coupe, un substrat transparent (8), une première électrode transparente (29) également appelée électrode inférieure, une couche (26) conductrice de type N, une couche active (23) de type Pérovskite, une couche (14) conductrice de type P et une seconde électrode (11), également appelée électrode supérieure en métal par exemple en argent ou en or et donc non transparente. Il convient de noter que, pour des raisons de clarté, les différents éléments sur la figure 1 sont représentés en échelle libre, les dimensions réelles des différentes couches n'étant pas respectées.

Si ces empilements permettent d'atteindre des performances relativement élevées, ils présentent néanmoins certaines insuffisances, notamment en terme de transparence; ce qui est un handicap certain pour notamment la réalisation de cellules tandem devant être éclairées par la couche conductrice de type P. Ainsi dans le cas de la figure 1, le dispositif PV est à éclairer depuis le substrat transparent puisque l'électrode supérieure est métallique et donc non transparente.

Pour pallier cette insuffisance, il a déjà été proposé l'utilisation, à titre d'électrode supérieure, de nano-fils d'argent ou d'oxydes transparents conducteurs, deux alternatives qui présentent un bon compromis transparence/conductivité. Malheureusement, la mise en œuvre de ces matériaux a également des limitations.

Ainsi, dans le cas des nano-fils, leur dépôt se fait par voie solvant, car, dans la majorité des cas, ces nano-fils se présentent sous forme de dispersions dans des solvants polaires. Or, les pérovskites utilisées pour des applications photovoltaïques sont sensibles à ces solvants, et de telles formulations ne peuvent donc être utilisées directement. Par ailleurs, des problèmes de résistance à l'interface sont généralement observés entre les matériaux de type P classiquement utilisés dans les dispositifs à base de pérovskites et les nano-fils.

Concernant les oxydes transparents / conducteurs, ceux-ci sont typiquement mis en œuvre via des procédés sous vide (e.g. PVD), qui permettent donc avantageusement de s'affranchir du problème de compatibilité chimique évoqué précédemment. Les dépôts d'oxyde d'indium dopé à l'étain (ITO) sont ainsi classiquement effectués dans une chambre sous vide secondaire par PVD (Physical Vapor Deposition) dans laquelle est introduit un gaz plasmagène. Toutefois, il peut également être constaté, dans cette variante, un endommagement « mécanique » des couches sous-jacentes lors du dépôt par PVD. C'est notamment le cas pour les couches de type P de type organique, comme par exemple le spiro-MeOTAD (matériau classiquement utilisé dans le domaine). Afin d'éviter l'endommagement de cette dernière lors du dépôt de l'électrode supérieure, il est donc nécessaire de former au préalable une couche d'oxyde métallique (e.g. MoOₓ) sur la couche P. Pour des raisons évidentes, ceci complexifie le procédé global de réalisation des dispositifs. De plus, en pratique, la nature de cette couche dépend du type d'architecture utilisée. Pour un empilement de type NIP, où le matériau de type P est classiquement du Spiro-OMeTAD ou un polymère conjugué, cette couche de protection est généralement un oxyde de molybdène ou de tungstène (Werner et al et al. Solar Energy Materials & Solar cells 141 (2015) 407-413). Pour un empilement de type PIN, où le matériau de type N est généralement un dérivé de type fullerène, cette couche de protection est généralement un oxyde d'étain (Bowring et al Adv. Energy Mater. 2018, 8).

Il demeure donc le besoin d'un procédé apte à former, au niveau d'un empilement incorporant un matériau pérovskite (PSCs), une électrode supérieure transparente d'une part sans altérer la couche sous-jacente dédiée à supporter cette électrode, ni le matériau pérovskite et d'autre part sans requérir la formation préalable d'une couche « interface » ou encore « tampon » entre cette électrode et sa couche support.

Contre toute attente, les inventeurs ont constaté que ces objectifs peuvent être atteints sous réserve de privilégier un matériau d'électrode spécifique et de retenir des conditions opératoires particulières pour former cette électrode supérieure au niveau de sa couche support de l'empilement considéré.

En particulier, la présente invention propose un procédé ne requérant pas la formation d'une couche « tampon » ou encore « interface » entre l'électrode supérieure transparente à former et la couche de l'empilement dédiée à la supporter.

La présente invention propose également un procédé non susceptible d'endommager la couche support de l'empilement, lors de la formation de l'électrode transparente directement à son contact.

Plus précisément, la présente invention vise à titre principal, un procédé utile pour former une électrode supérieure en oxyde conducteur transparent (TCO) (20) au contact d'une couche conductrice de type N d'un empilement pérovskite (PSCs) de type PIN ou d'une couche conductrice de type P d'un empilement pérovskite (PSCs) de type NIP, ledit procédé comportant au moins les étapes consistant à
a) disposer d'un empilement pérovskite multicouche de type NIP ou PIN (5) comportant au moins
   - un substrat (8) de préférence transparent
   - une électrode (15) supportée par le substrat, dite électrode inférieure, de préférence transparente,
   - une couche conductrice de type N (17), dite « couche de transport d'électrons »,
   - une couche active de type pérovskite (18) et ;
   - une couche conductrice de type P (19), dite « couche de transport de trous »
b) former, par dépôt physique en phase vapeur, sur tout ou partie de la couche conductrice de type N ou P présente en surface externe dudit empilement, une électrode supérieure en oxyde conducteur transparent (TCO) (20) via le bombardement ionique d'une cible composée d'un oxyde conducteur transparent (TCO), en présence d'oxygène et d'au moins un gaz vecteur inerte caractérisé en ce que
   ladite électrode transparente supérieure (TCO) (20) est formée directement au contact de ladite couche conductrice de type N ou P (17) ou (19) présente en surface externe dudit empilement, et en ce que le dépôt en phase vapeur est réalisé dans un réacteur sous vide à une température inférieure à 150°C avec un flux d'oxygène variant de 4,5 à 5,5 sccm, un flux de gaz vecteur inerte variant de 200 et 500 sccm et une puissance de dépôt variant de 1,0 à 30,0 kW/m².

Au sens de l'invention, l'expression directement au contact, signifie le défaut d'existence d'une couche de matériau annexe à l'intervalle ou encore interface de l'électrode supérieure transparente et la couche N ou P.

Au sens de l'invention, la désignation « électrode inférieure » qualifie l'électrode supportée par le substrat par opposition à l'électrode supérieure qui est la plus éloignée du substrat.

Avantageusement, l'oxyde métallique transparent conducteur TCO est un oxyde d'Indium dopé Etain (ITO), et en particulier formé à au moins 95% en masse d'In₂O₃ et moins de 5% en masse de SnO₂.

Selon une variante de réalisation, l'empilement considéré en étape a) est un empilement NIP et l'électrode (TCO) est formée au contact de sa couche P.

Selon une autre variante de réalisation, l'empilement considéré en étape a) est un empilement PIN et l'électrode (TCO) est formée au contact de sa couche N.

Selon un autre de ses aspects, la présente invention a pour objet un empilement multicouche NIP ou PIN comportant au moins
- un substrat (8) de préférence transparent
- une électrode dite inférieure (15), de préférence transparente,
- une couche conductrice de type N (17), dite « couche de transport d'électrons »,
- une couche active de type pérovskite (18) et ;
- une couche conductrice de type P (19), dite « couche de transport de trous » et
- une électrode transparente (TCO) dite supérieure, (20),
caractérisé en ce que ladite électrode transparente supérieure est directement au contact de la couche conductrice de type N dans un empilement PIN ou de la couche conductrice de type P dans un empilement NIP.

De préférence, ladite couche conductrice de type N dans le cas d'un empilement multicouche PIN, ou ladite couche conductrice de type P dans le cas d'un empilement multicouche NIP, en contact direct avec l'électrode transparente supérieure, est également en contact direct avec la couche active de type pérovskite.

De préférence, ladite couche conductrice d'interface entre la couche active de type pérovskite et l'électrode transparente supérieure (TCO), de type N dans le cas d'un empilement PIN et de type P dans le cas d'un empilement NIP, est une monocouche.

Autrement, cette couche d'interface est avantageusement distincte de structure conductrice multicouche, en particulier bicouche ou tri-couche.

Plus particulièrement, la présente invention a pour objet un empilement multicouche de structure NIP ou PIN comportant, en superposition, de manière jointive et dans l'ordre suivant, au moins :
- un substrat (8) de préférence transparent ;
- une électrode dite inférieure (15), de préférence transparente,
- une couche conductrice de type N (17), dite « couche de transport d'électrons » dans le cas d'une structure NIP, ou de type P, dite « couche de transport de trous » dans le cas d'une structure PIN,
- une couche active de type pérovskite (18),
- une couche conductrice de type P (19) dans le cas d'une structure NIP, et de type N dans le cas d'une structure PIN ; et
- une électrode transparente (TCO) dite supérieure, (20), formée selon le procédé de l'invention.

Selon une variante, l'empilement est de type NIP.

Selon une autre variante, l'empilement est de type PIN.

Avantageusement, l'électrode supérieure (TCO) est formée par dépôt physique en phase vapeur (ou PVD pour l'acronyme anglais de Physical Vapour Deposition) et en particulier selon le procédé de l'invention.

Selon une variante préférée, l'électrode supérieure (TCO) est une électrode en ITO.

Comme il ressort des exemples ci-après, les empilements de type pérovskite ainsi obtenus s'avèrent posséder les performances attendues en termes de transparence et de conductivité. Il n'est avantageusement pas constaté de dommage significatif au niveau des performances de conductivité des cellules photovoltaïques produites avec un empilement conforme à l'invention comparativement à un empilement dont l'électrode supérieure est un métal, et donc opaque.

Dans la suite du texte, les expressions « compris entre ... et ... », « allant de ... à ... » et « variant de ... à ... » sont équivalentes et entendent signifier que les bornes sont incluses, sauf mention contraire.

L'invention pourra être mieux comprise à la lecture de la description détaillée qui va suivre, donnée en référence aux dessins annexés.

### Description détaillée

### Electrode supérieure (TCO)

Au sens de l'invention, l'électrode (TCO) formée selon l'invention est dite supérieure à des fins de distinction de l'électrode dite inférieure qui est la première électrode réalisée au contact du substrat lors de la réalisation d'un empilement pour cellule photovoltaïque.

Au sens de l'invention, (TCO) signifie que l'électrode est formée d'un oxyde conducteur transparent.

Avantageusement, l'électrode supérieure transparente est classiquement formée d'oxyde(s) transparent(s) conducteur(s) (TCO) et peut être formée par exemple d'oxyde d'Indium dopé Etain (ITO), de ZnO dopé Aluminium (AZO), ZnO dopé Etain (ZTO), ZnO dopé au Gallium (GZO), ZnO dopé Indium (IZO), et/ou ZnO dopé Indium et Gallium (IGZO).

Par ailleurs, cette électrode transparente peut également être formée de deux ou trois couches de matériaux différents, par exemple ITO/Ag/ITO, AZO/Ag/AZO, AZO/Au/AZO, AZO/Ag/ZnO, ou encore ZnO/Ag/ZnO.

De préférence, l'électrode transparente est à base d'un matériau choisi parmi l'oxyde d'indium dopé à l'étain (communément dénommé ITO pour l'appellation anglaise « Indium Tin Oxide »), l'oxyde de zinc dopé à l'indium (communément dénommé IZO pour l'appellation anglaise « Indium Zinc Oxide »), l'oxyde de zinc de préférence dopé, et leurs mélanges.

Cette électrode peut présenter une épaisseur comprise entre 50 nm et 1000 nm, en particulier entre 100 et 500 nm.

Comme énoncé précédemment elle est directement au contact de la couche P ou de la couche N et de préférence de la couche P comme illustré en figure 2. Le contact avec la couche P s'effectue sur l'ensemble de sa face supérieure définissant ainsi une surface de contact.

### Couche active de type pérovskite

Cette couche active est formée d'un matériau pérovskite et plus particulièrement de formule générale ABX₃, avec :
- A représentant un cation ou une combinaison de cations métalliques ou organiques ;
- B représentant un ou plusieurs éléments métalliques, tels que le plomb (Pb), l'étain (Sn), le bismuth (Bi) et l'antimoine (Sb) ; et
- X représentant un ou plusieurs anions, en particulier un ou plusieurs halogènes, et plus particulièrement choisis parmi le chlore, le brome, l'iode et leurs mélanges.

De tels matériaux pérovskites sont notamment décrits dans le document WO 2015/080990.

A titre d'exemple de matériaux pérovskites, on peut en particulier citer les pérovskites hybrides organiques-inorganiques. Ces matériaux pérovskites hybrides peuvent être plus particulièrement de formule ABX₃ précitée, dans laquelle A comprend un ou plusieurs cations organiques.

Un tel cation organique peut être choisi parmi les cations organo-ammonium tels que
- les cations alkyl-ammonium de formule générale R₁R₂R₃R₄N⁺ avec R₁, R₂, R₃ et R₄ étant indépendamment l'un de l'autre un atome d'hydrogène ou un radical alkyle en C₁-C₅ comme par exemple un cation de type méthylammonium (MA) et
- les cations formamidinium (FA) de formule [R₁NCHNR₁]⁺, avec R₁ pouvant représenter un atome d'hydrogène ou un radical alkyle en C₁-C₅

Le ou les cations organiques du matériau pérovskite hybride peuvent être éventuellement associés à un ou plusieurs cations métalliques, par exemple du césium et/ou du rubidium.

A titre d'exemples de matériaux pérovskites hybrides, on peut plus particulièrement citer les pérovskites de formule ABX₃, avec
- A représentant un cation organo-ammonium par exemple de type méthylammonium (MA), un cation formamidinium (FA) ou un mélange de ces deux cations, éventuellement associé à du césium;
- B étant choisi parmi le plomb, l'étain, le bismuth, l'antimoine et leurs mélanges et
- X étant choisi parmi le chlore, le brome, l'iode et leurs mélanges.

Le matériau pérovskite peut être en particulier CH₃NH₃PbI₃, dit encore PK avec le plomb pouvant être remplacé par l'étain ou le germanium et l'iode pouvant être remplacé par le chlore ou le brome.

Le matériau pérovskite peut également être un composé de formule CsₓFA₁₋ₓPb(I_{1-y}Br_{y}) avec x < 0.17 ; 0 < y < 1 et FA symbolisant le cation formamidinium.

### Couche conductrice de type N

Un matériau « de type N » désigne un matériau qui permet le transport des électrons (e⁻).

Un tel matériau peut être formé de nanoparticules d'oxyde(s) métallique(s) de type N comme par exemple l'oxyde de zinc ZnO, les oxydes de titane TiOₓ avec x compris entre 1 et 2, l'oxyde d'étain (SnO₂), les oxydes de zinc dopés, par exemple l'oxyde de zinc dopé à l'aluminium (AZO), l'oxyde de zinc dopé à l'indium (IZO), l'oxyde de zinc dopé au gallium (GZO), les oxydes de titane dopés, par exemple l'oxyde de titane dopé à l'azote, au phosphore, au fer, au tungstène ou au manganèse et leurs mélanges.

Il peut également s'agir d'un matériau carboné semi-conducteur de type N contenant au moins un motif choisi parmi les motifs
- éthylèneimine comme par exemple le polyéthylènimine éthoxylé (PEIE),
- thiophène comme un thiophène-C61-butyrate de méthyle
- fluorène comme par exemple le poly[(9,9-bis(3'-(N,N-diméthylamino)propyl)-2,7-fluorène)-alt-2,7-(9,9-dioctylfluorène) (PFN) ;
- pérylènes ;
- fullerènes, par exemple le fullerène C60, le fullerène C70, le fullerène C80, le fullerène C84 ou un multi-adduit d'un fullerène C60 ou C70.

Ce matériau carboné semi-conducteur de type N peut être également choisi parmi les nano-tubes de carbone semi-conducteurs ; le graphène et les nanographènes et leurs dérivés solubles.

A titre illustratif de ces matériaux carbonés semi-conducteur de type N peuvent être tout particulièrement cités le [6,6]-phényl-C61-butyrate de méthyle dit PCBM ou PC61BM, le [6,6]-phényl-C71-butyrate de méthyle dit PC71BM, un thiophène-C61-butyrate de méthyle, un multi-adduit d'un fullerène C60 ou C70 ou des nanotubes de carbone fonctionnalisés.

Des matériaux de type N préférés sont SnO₂, ZnO et TiOₓ avec x tel que défini ci-dessus.

De préférence, ladite couche conductrice de type N est formée à plus de 90 % massique d'un unique matériau de type N, voire à plus de 95 % massique d'un unique matériau de type N, voire est formée entièrement d'un unique matériau de type N.

### Couche conductrice de type P

Un matériau de type P permet le transport des trous.

Le matériau de type P peut être par exemple choisi parmi les poly(styrène sulfonate) de sodium (PSS), le Nafion, WO₃, MoO₃, V₂O₅ et NiO, les polymères pi-conjugués et leurs mélanges.

A titre illustratif des polymères semi-conducteurs π-conjugués peuvent notamment être cités le poly(3,4-éthylènedioxythiophène) (PEDOT) les poly(3-hexylthiophène) ou P3HT, poly[N-9'-heptadecanyl-2,7-carbazole-alt-5,5-(4,7-di-2-thienyl-2',1',3'-benzothiadiazole ou PCDTBT, poly[2,1,3-benzothiadiazole-4,7-diyl[4,4-bis(2-ethylhexyl)-4H-cyclopenta[2,1-b:3,4-b']dithiophene-2,6-diyl]] ou PCPDTBT, le Poly(benzo[1,2-b:4,5-b']dithiophene-alt-thieno[3,4-c]pyrrole-4,6-dione) PBDTTPD, poly[[4,8-bis[(2-ethylhexyl)oxy]benzo[1,2-b:4,5-b']dithiophene-2,6-diyl][3-fluoro-2-[(2-ethylhexyl)carbonyl]thieno[3,4-b]thiophenediyl]] ou PTB7.

Un matériau de type P préféré est un mélange de PEDOT et de PSS.

### Electrode inférieure

L'électrode inférieure 15, au contact du substrat, peut par exemple être formée d'une couche en un matériau choisi parmi les oxydes conducteurs transparents (TCO) tels que l'oxyde d'étain dopé à l'indium (ITO), l'oxyde de zinc dopé à l'aluminium (AZO), l'oxyde de zinc dopé au gallium (GZO), l'oxyde de zinc dopé à l'indium (IZO) et leurs mélanges, ou formée d'un ensemble multicouche, par exemple AZO/Ag/AZO.

Elle peut également être formée par une couche en argent, par un réseau de nanofils, de préférence en argent.

### Substrat

Le terme « substrat » fait référence à une structure de base solide, sur une des faces de laquelle est formée l'électrode inférieure.

Le substrat 8 d'un empilement multicouche selon l'invention peut être par exemple en polyester, en particulier en polyéthylène téréphtalate (PET), en polyéthylène naphtalate ou en polycarbonates. Il peut encore se présenter sous la forme d'une plaque en verre.

Bien entendu, la nature du substrat dépend là encore du dispositif électronique (photovoltaïque, diode électroluminescente, etc.) visé.

A titre représentatif d'empilements convenant à l'invention, peuvent notamment être cités ceux figurant ci-après
Substrat / ITO / SnO₂ / PK / PEDOT:PSS / ITO
Substrat / ITO / PEDOT:PSS / PK / C₆₀ / ITO
Substrat / ITO / PEDOT:PSS / PK / SnO₂ / ITO

De préférence, le substrat est un verre.

### PROCEDE DE FABRICATION

Comme énoncé précédemment, les inventeurs ont constaté que la réalisation d'une électrode transparente (TCO) directement au contact d'une couche P dans un empilement pérovskite de type NIP ou d'une couche N dans un empilement pérovskite de type PIN est réalisable sans risque d'endommagement de ces couches sous réserve de sélectionner une technique particulière pour former cette électrode.

Ainsi, dans le cadre de l'invention, cette électrode supérieure (TCO) est formée au contact de sa couche support de type N ou P et de préférence de type P, par dépôt chimique en phase vapeur assisté par plasma.

Plus précisément, son dépôt peut être réalisé par la technique dite Physical Vapour Deposition (PVD). Cette technique est déjà connue comme étant utile pour déposer des matériaux en couche mince sur un substrat à partir d'un état gazeux (vapeur) dans un réacteur préalablement mis sous vide secondaire. Ainsi, quand il s'agit de déposer un matériau semi-conducteur transparent, il est procédé dans le réacteur, à un bombardement ionique du matériau source dit encore cible via un plasma généré dans ce réacteur, en présence d'au moins un gaz inerte notamment l'argon. Ce plasma est créé par une décharge électrique radio-fréquence en 2 électrodes et les espèces sont générées, à partir du matériau source dit encore cible, par collision avec les électrons (réactions primaires) ou entre elles lorsqu'elles sont réactives (réactions secondaires).

Plus particulièrement, les inventeurs ont découvert que l'ajustement de conditions bien spécifiques à cette technique de dépôt par PVD permet d'accéder, selon un mode opératoire en outre simplifié, à des empilements permettent de répondre efficacement aux attentes en termes de transparence et de rendement photovoltaïques.

Ainsi, lors de l'opération de dépôt, le flux en oxygène est ajusté dans le réacteur plasma entre 4,5 et 5,5 sccm et en particulier à environ 5 sccm.

Par ailleurs, un flux de gaz inerte, de préférence de l'argon, est également introduit dans le réacteur plasma, notamment entre 200 et 500 sccm et de préférence entre 300 et 400 sccm.

La densité de puissance utilisée pour générer le plasma est avantageusement ajustée à une valeur variant de 1,0 à 30,0 kW/m², de préférence de 2,5 à 14,5 kW/m².

Cette puissance est modulable selon que la couche conductrice doit être réalisée ou non en un unique dépôt.

Il est ainsi possible de moduler l'épaisseur de la couche formée en ajustant la puissance utilisée. Comme illustré dans les exemples ci-après, une puissance de 14,2 kW/m² est propice à un dépôt d'environ 100 nm d'épaisseur, une puissance de 5,7 kW/m² à un dépôt de 40 nm d'épaisseur et une puissance de 2,8 kW/m² à un dépôt de 20 nm d'épaisseur.

Dans la variante où elle doit être réalisée en un unique dépôt, il est avantageux de privilégier une puissance maximale c'est-à-dire au moins égale à 14 kW/m².

Dans la variante où cette couche est à réaliser par superposition de plusieurs sous-couches, pouvant être notamment de compositions différentes, il est privilégié une puissance moindre et notamment inférieure à 6,0 kW/m², en particulier de l'ordre de 2,8 kW/m². Dans cette variante, l'empilement des différentes sous-couches est réalisé au cours du même cycle de dépôt, sans arrêter le plasma.

Selon un mode de réalisation particulier, l'électrode supérieure (TCO) est opérée par dépôt en phase vapeur dans un réacteur sous vide, dans des conditions de flux d'oxygène de 4,5 sccm, de flux de gaz vecteur inerte, de préférence d'argon, compris entre 300 et 330 sccm et avec une puissance de dépôt variant entre 10 et 20 kW/m².

La température dans la chambre de dépôt du réacteur est inférieure à 150°C et de préférence varie de 100 à 120°C.

En ce qui concerne le matériau source ou encore dit la cible, véhiculé par le flux gazeux, il comprend au moins un oxyde métallique transparent, et le cas échéant son matériau dopant, dédié(s) à former la couche conductrice transparente.

Cet oxyde métallique peut être choisi parmi les oxydes métalliques précisés ci-dessus à titre de constituants de la couche conductrice transparente.

Selon une variante particulière, il s'agit d'un mélange formé d'au moins 95 % en masse d'In₂O₃ et moins de 5 % masse de SnO₂.

La vitesse de déplacement du substrat au sein du réacteur est avantageusement comprise entre 1 et 10 mm/s, de préférence entre 2 et 5 mm/s.

Comme il ressort des exemples ci-après, la réalisation de ce dépôt selon des spécificités définies permet d'accéder à un empilement apte à procurer les performances avantageuses en termes de transparence et de conductivité.

En outre, le procédé conforme à l'invention a pour avantage significatif de ne pas requérir la formation d'une couche dite « tampon » entre l'électrode (TCO) et sa couche support de type N ou P. Pour des raisons évidentes, cette non nécessité de couche tampon représente un avantage significatif en termes de simplification du procédé de production.

En ce qui concerne les autres couches constitutives de l'empilement selon l'invention, leur dépôt est au préalable réalisé par une technique conventionnelle.

Par exemple, le dépôt d'une solution au cours du procédé de fabrication, en particulier pour former chacune des couches N, P et la couche active de pérovskite peut être réalisé au moyen d'une technique choisie parmi le dépôt à la tournette ou enduction centrifuge (« spin-coating » en langue anglaise), le dépôt au racloir, le couchage à lame (« blade-coating » en langue anglaise), le dépôt par spray ultrasonique, l'enduction par filière à fente (« slot-die » en langue anglaise), l'impression jet d'encre, l'héliogravure, la flexographie et la sérigraphie.

Notamment, tous les revêtements formés au cours des étapes du procédé peuvent être effectués à l'aide d'une unique technique choisie parmi celles décrites ci-dessus.

La technique de dépôt peut être choisie par l'homme du métier en fonction des propriétés de fluidité et des constituants de la solution à déposer.

Une couche peut être obtenue par au moins une, voire plusieurs étapes de dépôt. Avantageusement, ces étapes de dépôt peuvent être effectuées par voie humide.

### DISPOSITIF PHOTOVOLTAIQUE

Un empilement multicouche selon l'invention est particulièrement intéressant pour un dispositif photovoltaïque.

Ainsi, l'invention vise également un dispositif photovoltaïque comprenant au moins ledit empilement et/ou un dispositif photovoltaïque obtenu selon le procédé décrit ci-dessus.

Ce dispositif est en particulier une cellule photovoltaïque notamment choisie parmi les cellules pérovskites semi-transparentes ou encore les cellules tandems silicium pérovskites.

La figure 2, rend compte d'une architecture d'empilement selon l'invention convenant pour la réalisation de telles cellules. Cet empilement de type NIP comporte en superposition, de manière jointive et dans l'ordre suivant :
- un substrat (8), de préférence transparent, se présentant de préférence sous la forme d'une plaque, par exemple en verre ou en matière plastique, de préférence en PEN et/ou en PET,
- une électrode inférieure (15),
- une couche conductrice de type N (17),
- une couche active de type pérovskite (18),
- une couche conductrice de type P (19), et
- une électrode supérieure (TCO) (20).

Autrement dit, ladite couche conductrice de type P, en contact direct avec l'électrode supérieure (TCO), est également en contact direct avec la couche active de type pérovskite (18).

Il est entendu que, de manière similaire, dans le cas d'un empilement de type PIN, c'est la couche conductrice de type N, en contact direct avec l'électrode supérieure (TCO), qui est également en contact direct avec la couche active de type pérovskite.

Autrement dit, dans le cas d'un empilement de type PIN, celui peut plus particulièrement comporter, en superposition, de manière jointive et dans l'ordre suivant :
- un substrat, de préférence transparent, se présentant de préférence sous la forme d'une plaque, par exemple en verre ou en matière plastique, de préférence en PEN et/ou en PET,
- une électrode inférieure,
- une couche conductrice de type P,
- une couche active de type pérovskite,
- une couche conductrice de type N,
- une électrode supérieure (TCO).

Une cellule photovoltaïque comporte en outre des moyens de connexion électrique (non représentés sur la figure 2), notamment des reprises de contact, qui permettent de relier les électrodes.

Bien entendu, l'invention n'est pas limitée au module spécifique décrit ci-dessus, et d'autres applications de l'empilement selon l'invention peuvent être envisagées.

Les figures et exemples figurant ci-après sont présentés à titre illustratif et non limitatif des modes de réalisation de l'invention.

### Brève description des dessins

[Fig 1] La figure 1 décrit, comme détaillé ci-dessus une cellule photovoltaïque de type pérovskite de type NIP conventionnelle.
[Fig 2] La figure 2 rend compte d'une architecture d'empilement selon l'invention.

### MATERIAUX ET METHODES

### 1. Méthodes de mesure

Les performances photovoltaïques des cellules sont mesurées en enregistrant les caractéristiques courant-tension des dispositifs sur un appareil Keithley® SMU 2600 sous éclairement AM 1,5G à une puissance de 1000 W.m⁻².

La cellule testée est éclairée au travers de la face Verre/ITO à l'aide d'un simulateur Oriel.

Les paramètres caractéristiques du fonctionnement des dispositifs (Tension de circuit ouvert Voc, densité de courant de court-circuit Jsc, facteur de forme FF et rendement de conversion PCE) sont déterminés.

Les performances ont été mesurées à 25°C dans des conditions standards d'éclairement (1000 W/m², AM 1,5 G).

### 2. Empilement de base

L'empilement de base est un empilement verre-ITO-AZO-Pérovskite-P3HT

La couche d'AZO, d'une épaisseur de 50 nm est réalisée à partir d'une dispersion de nanoparticules (diamètre moyen < 10 nm) dans l'isopropanol.

La couche pérovskite est de type MAPbI3 et a une épaisseur de 300 nm

La couche de P3HT a une épaisseur d'environ 80 nm et est réalisée à partir d'une solution du polymère dans le chlorobenzène.

### 3. Mise en œuvre du réacteur sous vide à plasma

La réalisation de l'électrode supérieure transparente ITO est élaborée par bombardement ionique. L'enceinte d'installation de pulvérisation est évacuée jusqu'au vide secondaire (quelques 10⁻⁷ torr) et remplie par un gaz plasmagène (Ar) jusqu'à la pression de 1 à 7.10⁻³ torr. Une décharge électrique crée le plasma et les ions positifs sont accélérés vers la cathode-cible (appelée ainsi car elle attire les cations) sous un potentiel négatif de 0,1 à 1,0 kV, tandis que les autres parties de la chambre sont reliées à la masse. Les atomes (particules neutres) éjectés de la cible vont se déposer sur les parois proches environnantes. Le système utilisé est dynamique, c'est-à-dire que le suscepteur est mobile, il ne subit le dépôt que lorsqu'il passe sous la cible. Autre point, c'est un procédé magnétron, plus efficace que la pulvérisation diode classique. L'effet magnétron réside en une décharge diode entretenue par des électrons secondaires éjectés de la cathode sous l'effet du bombardement ionique. Une contre plaque aimantée, placée derrière la cathode, créée un champ magnétique parallèle à la cible qui tend à enrouler les trajectoires électroniques autour des lignes de champ, augmentant considérablement les chances d'ioniser une molécule de gaz au voisinage de la cathode. Il s'ensuit une ionisation plus importante des gaz contenus dans l'enceinte, améliorant de ce fait le rendement de pulvérisation de la cible ; la vitesse de dépôt est augmentée et la pression de maintien du plasma est abaissée.

### EXEMPLE 1

Préparation d'un empilement conforme à l'invention et caractérisation de ses performances.

L'empilement de base décrit dans le développement matériaux et méthodes a été considéré pour préparer un empilement conforme à l'invention en considérant, à titre de matériau source dit encore cible, un matériau ITO et trois puissances de dépôts différentes à savoir :
1 : 14,2 kW /m² pour former une couche de 100 nm d'ITO,
2 : 5,7 kW/m² pour former une couche de 40 nm d'ITO, et
3 : 2,8 kW /m² pour former une couche de 20 nm d'ITO.

Les valeurs des flux d'oxygène et d'argon et la vitesse de déplacement sont identiques à celles renseignées dans le tableau 1 ci-après.

**[Tableaux 1]**

| Empilement | Puissance (kW/m²) | Flux d'Oxygène (sccm) | Flux d'Argon (sccm) | Vitesse de déplacement (mm/s) |
|---|---|---|---|---|
| 1 | 14,2 | 4,5 | 315 | 5 |
| 2 | 2,8 | 4,5 | 315 | 2 |
| 3 | 14,2 | 4,5 | 450 | 5 |
| 4 | 5,7 | 4,5 | 450 | 2 |

### a) Mesure de la transparence

Pour chaque empilement, l'absorption de la pérovskite a été appréciée avant et après dépôt de l'électrode semi-transparente.

Quelle que soit la puissance considérée et donc l'épaisseur de la couche conductrice formée, les propriétés d'absorbance des empilements ainsi formées ne sont avantageusement pas modifiées significativement par rapport à celles de l'empilement de base.

### b) Mesure de l'impact d'un empilement conforme à l'invention sur le rendement d'une cellule photovoltaïque.

Des cellules photovoltaïques ont été élaborées en considérant 4 empilements conformes à l'invention préparés selon 4 variantes du procédé selon l'invention et dont les spécificités sont détaillées dans le tableau 1 ci-dessus.

Le matériau ITO utilisé est tel que défini ci-dessus.

Chacune des cellules photovoltaïques intègre la couche d'ITO entre la couche P et l'électrode d'or selon un empilement Verre / ITO / AZO / PK / P3HT / ITO / Au.

La cellule de référence est Verre / ITO / AZO / PK / P3HT / Au.

Les performances photovoltaïques ont été testées pour chacune des 4 cellules ainsi formées.

Les valeurs obtenues sont renseignées dans les tableaux 3 à 6, figurant ci-après.

**[Tableaux 2]**

| Voc (mV) | Jsc (mA/cm²) | FF(%) | Rendement(%) |
|---|---|---|---|
| 929,8 +/- 38,3 | 17, 6 +/- 2,5 | 54, 7 +/- 7,1 | 8,9 +/- 1,4 |

| | | | |
|---|---|---|---|
| Caractéristiques de la cellule de référence | | | |

**[Tableaux 3]**

| Voc (mV) | Jsc (mA/cm²) | FF(%) | Rendement(%) |
|---|---|---|---|
| 911,0 +/- 9,8 | 17,3+/-1,2 | 56,6 +/- 3.4 | 8,9 +/- 0,4 |

| | | | |
|---|---|---|---|
| Caractéristiques des cellules incorporant l'empilement 1 | | | |

**[Tableaux 4]**

| Voc (mV) | Jsc (mA/cm²) | FF(%) | Rendement(%) |
|---|---|---|---|
| 882,5 +/- 6,6 | 15,2 +/- 2,4 | 56,9 +/- 1,4 | 7,7 +/- 1,3 |

| | | | |
|---|---|---|---|
| Caractéristiques des cellules incorporant l'empilement 2 | | | |

**[Tableaux 5]**

| Voc (mV) | Jsc (mA/cm²) | FF(%) | Rendement(%) |
|---|---|---|---|
| 883,4 +/- 28,8 | 17,7 +/- 0,4 | 51,4 +/- 3,2 | 8,0 +/- 0,5 |

| | | | |
|---|---|---|---|
| Caractéristiques des cellules incorporant l'empilement 3 | | | |

**[Tableaux 6]**

| Voc (mV) | Jsc (mA/cm²) | FF(%) | Rendement(%) |
|---|---|---|---|
| 924,9 +/- 40,6 | 17,3 +/- 1,6 | 49,9 +/- 2,2 | 8,0 +/- 0,5 |

| | | | |
|---|---|---|---|
| Caractéristiques des cellules incorporant l'empilement 4 | | | |

Il est ainsi constaté que le dépôt d'ITO par plasma n'entraîne pas de perte majeure de rendement des cellules voire même n'a aucun impact dans le cas de la cellule incorporant l'empilement 1.

## Revendications

1. Procédé utile pour former une électrode supérieure en oxyde conducteur transparent (TCO) au contact d'une couche conductrice de type N d'un empilement pérovskite (PSCs) de type PIN ou d'une couche conductrice de type P d'un empilement pérovskite (PSCs) de type NIP, ledit procédé comportant au moins les étapes consistant à
a) disposer d'un empilement pérovskite multicouche de type NIP ou PIN (5) comportant au moins
• un substrat (8) de préférence transparent
• une électrode (15) supportée par le substrat, dite électrode inférieure, de préférence transparente,
• une couche conductrice de type N (17), dite « couche de transport d'électrons »,
• une couche active de type pérovskite (18) et ;
• une couche conductrice de type P (19), dite « couche de transport de trous »
b) former, par dépôt physique en phase vapeur, sur tout ou partie de la couche conductrice de type N ou P présente en surface externe dudit empilement, une électrode transparente supérieure en oxyde conducteur transparent (TCO) (20) via le bombardement ionique d'une cible composée d'un oxyde conducteur transparent (TCO), en présence d'oxygène et d'au moins un gaz vecteur inerte **caractérisé en ce que**
ladite électrode supérieure (TCO) (20) est formée directement au contact de ladite couche conductrice de type N ou P (17) ou (19) présente en surface externe dudit empilement, et **en ce que** le dépôt en phase vapeur est réalisé dans un réacteur sous vide à une température inférieure à 150°C avec un flux d'oxygène variant de 4,5 à 5,5 sccm, un flux de gaz vecteur inerte variant de 200 et 500 sccm et une puissance de dépôt variant de 1,0 à 30,0 kW/m².

2. Procédé selon la revendication 1 dans lequel l'empilement considéré en étape a) est un empilement NIP et l'électrode (TCO) est formée au contact de sa couche P.

3. Procédé selon la revendication 1 dans lequel l'empilement considéré en étape a) est un empilement PIN et l'électrode (TCO) est formée au contact de sa couche N.

4. Procédé selon la revendication 1 à 3 dans lequel l'oxyde transparent conducteur TCO est un matériau ITO, en particulier formé à au moins 95% en masse d'In₂O₃ et moins de 5% en masse de SnO₂.

5. Procédé selon l'une quelconque des revendications précédentes dans lequel la température au sein du réacteur varie de 100 à 120°C.

6. Procédé selon l'une quelconque des revendications précédentes dans lequel ledit matériau cible est un mélange formé d'au moins 95 % en masse d'In₂O₃ et moins de 5 % masse de SnO₂.

7. Empilement multicouche de structure NIP ou PIN comportant, en superposition, de manière jointive et dans l'ordre suivant, au moins
• un substrat (8) de préférence transparent
• une électrode dite inférieure (15), de préférence transparente,
• une couche conductrice de type N (17), dite « couche de transport d'électrons » dans le cas d'une structure NIP, ou de type P, dite « couche de transport de trous » dans le cas d'une structure PIN,
• une couche active de type pérovskite (18) et ;
• une couche conductrice de type P (19) dans le cas d'une structure NIP, et de type N dans le cas d'une structure PIN ; et
• une électrode transparente (TCO) dite supérieure, (20), formée selon l'une quelconque des revendications 1 à 6.

8. Empilement selon la revendication précédente **caractérisé en ce que** l'empilement est NIP et l'électrode supérieure (TCO) est directement au contact de ladite couche P.

9. Empilement selon la revendication 7 ou 8 dans lequel ladite électrode supérieure (TCO) est formée d'au moins un matériau choisi parmi les oxyde d'indium dopé étain (ITO), ZnO dopé Aluminium (AZO), ZnO dopé Etain (ZTO), ZnO dopé au Gallium (GZO), ZnO dopé Indium (IZO), ZnO dopé Indium et Gallium (IGZO).

10. Empilement selon l'une quelconque des revendications 7 à 9 dans lequel ladite électrode supérieure possède une épaisseur comprise entre 50 nm et 1000 nm, en particulier entre 100 et 500 nm.

11. Dispositif photovoltaïque comprenant au moins un empilement selon l'une des revendications 7 à 10.

12. Dispositif selon la revendication précédente **caractérisé en ce qu'**il s'agit d'une cellule photovoltaïque notamment une cellule pérovskite de préférence semi-transparente ou une cellule tandem silicium pérovskite.
